# EUROPEAN PATENT SPECIFICATION

(11) **EP 2 473 646 B1**
(45) Date of publication and mention of the grant of the patent: **05.12.2018**
(21) Application number: 10760155.1
(22) Date of filing: 02.09.2010
(51) Int. Cl.: C23C 14/12, C23C 14/56, C23C 14/22

(54) **ORGANIC VAPOR JET PRINTING DEVICE WITH A CHILLER PLATE**
VORRICHTUNG ZUR STRAHLAUFDAMPFUNG ORGANISCHER DÄMPFE MIT EINER KÜHLPLATTE
DISPOSITIF D'IMPRIMANTE À JET DE VAPEURS ORGANIQUES AVEC PLAQUE DE REFROIDISSEMENT

(30) Priority: 03.09.2009 US 239656 P; 27.08.2010 US 870125
(43) Date of publication of application: 11.07.2012
(73) Proprietor: Universal Display Corporation, Ewing, NJ 08618 (US)
(72) Inventor: BURROWS, Paul E., Ewing, NJ 08618 (US); MOHAN, Siddharth Harikrishna, Ewing, NJ 08618 (US)
(74) Representative: Maiwald Patent- und Rechtsanwaltsgesellschaft mbH
(86) International application number: PCT/US2010/047625
(87) International publication number: WO 2011/028867

(56) References cited:
- WO-A1-03/020999
- WO-A1-2009/034916
- WO-A2-2010/127328
- JP-A- 2004 259 634
- SHTEIN MAX ET AL: "Material transport regimes and mechanisms for growth of molecular organic thin films using low-pressure organic vapor phase deposition" JOURNAL OF APPLIED PHYSICS, AMERICAN INSTITUTE OF PHYSICS. NEW YORK, US LNKD- DOI:10.1063/1.1332419, vol. 89, no. 2, 15 January 2001 (2001-01-15), pages 1470-1476, XP012052809 ISSN: 0021-8979

## Description

### FIELD OF THE INVENTION

The present invention relates to organic vapor jet printing (OVJP).

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745, which are incorporated herein by reference in their entirety.

One way to deposit OLEDs and other organic devices is Organic Vapor Jet Printing (OVJP). The general principle of OVJP has been described in WO03/020999 A1, U.S. Patent No. 7,404,862, U.S. Patent Applications Nos. US2004048000 A, US2005087131 A and US2011045196.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

More details on OLEDs, and the definitions described above, can be found in US Pat. No. 7,279,704, which is incorporated herein by reference in its entirety.

### SUMMARY OF THE INVENTION

The present invention relates to an organic vapor jet printing device according to claim 1 and an organic vapor jet printing method according to claim 17.

A device is provided. The device includes a nozzle, a source of carrier gas and a source of organic molecules in fluid communication with the nozzle. The device also includes an active cooling system disposed adjacent to the nozzle.

Preferably, the device also includes a chamber, wherein the nozzle, and the active cooling system are disposed within the chamber. A substrate holder may also be disposed within the chamber, adapted to support a substrate beneath the nozzle, movable relative to the nozzle. Preferably, a substrate is held by the substrate holder, the substrate disposed at a distance of 0.1 to 10 mm from the active cooling system.

Preferably, the device also includes a heating system attached to the nozzle. The points at which the heating system are attached to the nozzle preferably includes at least one point that is zero to 5 mm from the tip of the nozzle.

An example of an active cooling system is a plate having an aperture therein, where the nozzle extends through the aperture. Preferably, the nozzle protrudes from the aperture by zero to 10 mm. Preferably, the nozzle protrudes from the aperture by 0 to 10 times the diameter of the interior of the nozzle at its tip. The active cooling system may include cooling fluid channels in the plate, or attached to the plate, such as the back of the plate. Preferred cooling fluids include ethylene glycol and liquid nitrogen. Preferably, the active cooling system is adapted to maintain a plate temperature of -100C to 100C. Another example of an active cooling system is a cooling fluid tube wrapped around the heating system.

The device may include multiple nozzles, wherein the active cooling system is disposed adjacent to each nozzle and / or between two or more nozzles.

Preferably, the device includes a thermal insulating material disposed between the nozzle and the active cooling system.

An example of a device having an active cooling system and a heating system is a nozzle having as a heating system a resistive wire wrapped around the nozzle, with the active cooling system being a cooling fluid tube wrapped around the heating system.

The device may include a thermoelectric cooler having a hot side and a cool side, where the cool side of the thermoelectric cooler is the active cooling system, and the hot side of the thermoelectric cooler is part of the heating system.

A method of depositing organic molecules via OVJP is provided. A nozzle, a source of carrier gas and a source of organic molecules in fluid communication with the nozzle, an active cooling system disposed adjacent to the nozzle, and a heating system attached to the nozzle are provided. Organic molecules are deposited onto a substrate by ejecting through the nozzle the organic molecules carried by the carrier gas. While depositing the organic molecules, the nozzle is heated with the active heating system, and the active cooling system is maintained at a cool temperature, lower than it would be in the absence of active cooling.

Preferably, the substrate is disposed at a distance of 0.1 to 10 mm from the active cooling system while the organic molecules are being deposited. Preferably, the active cooling system is maintained at a temperature of -100C to 100C while the organic molecules are being deposited. Preferably, multiple nozzles are provided, where the active cooling system is disposed adjacent to each nozzle. Preferably, organic molecules are deposited to a thickness of 10 nm to 5000 nm in regions of the substrate underneath the nozzles, and where any organic molecules are deposited in regions of the substrate not underneath the nozzles, they are deposited to a thickness of zero to one monolayer. Preferably, the nozzle is maintained at a temperature of 150C to 400C while the organic molecules are being deposited.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows an example of a nozzle with an adjacent active cooling system.
FIG. 4 shows an OVJP system that does not have an active cooling system, contrasted to an OVJP system that does have an active cooling system.
FIG. 5 shows a series of devices used to illustrate issues with devices caused by overspray
FIG. 6 shows two emission spectra from one of the devices of FIG. 5, where one spectra is from a device that includes a layer deposited via OVJP without an active cooling system, and the other is from a device that includes a layer deposited via OVJP with an active cooling system.

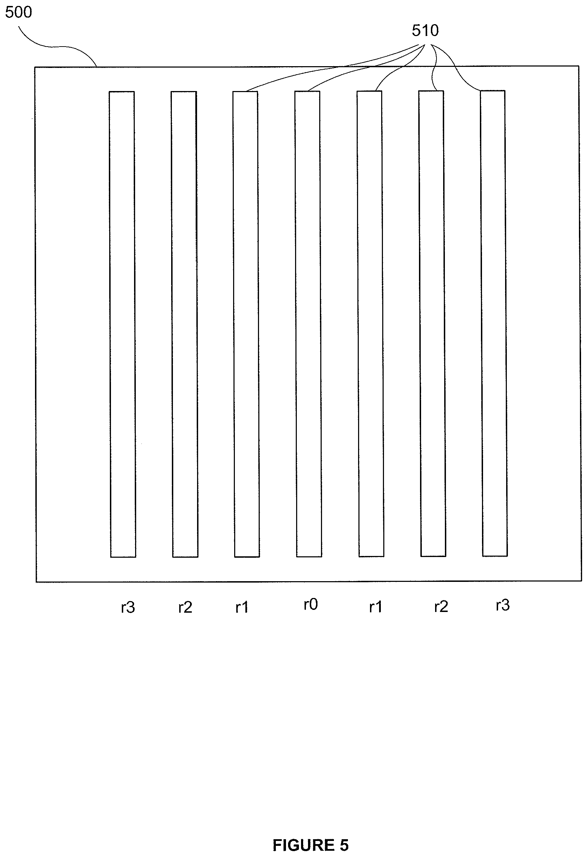

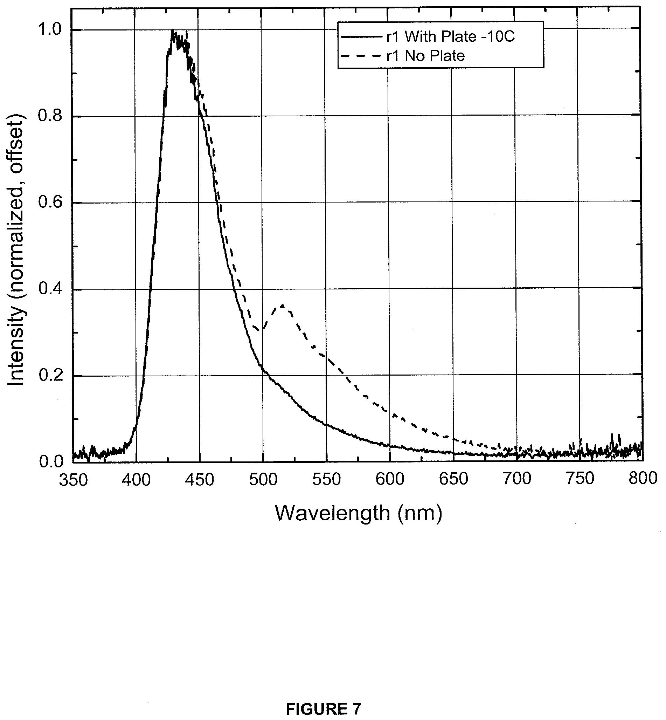

FIGS. 7 through 9 each show two emission spectra from one of the devices of FIG. 5. One spectra is from a device that is near a device having a layer deposited via OVJP without an active cooling system, and the other is from a device that is near a device that includes a layer deposited via OVJP with an active cooling system. The devices for which spectra are shown in FIGS. 7 through 9 do not include a layer deposited via OVJP, but rather may include some overspray from a nearby layer deposited via OVJP. The devices of FIGS. 7 through 9 are progressively further away from the device having a layer deposited via OVJP.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

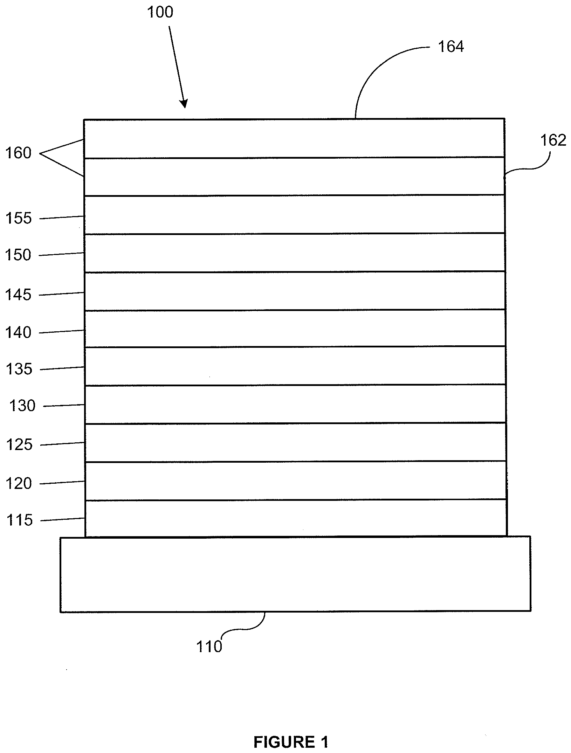

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, and a cathode 160. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F.sub.4-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

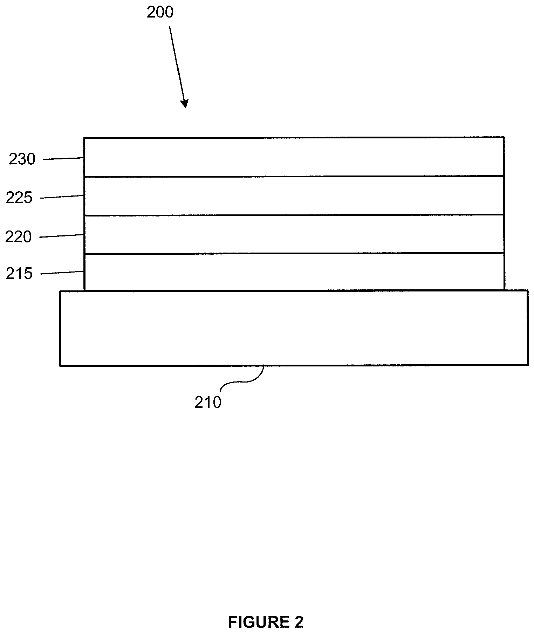

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of nonlimiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJP. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the invention may be incorporated into a wide variety of consumer products, including flat panel displays, computer monitors, televisions, billboards, lights for interior or exterior illumination and/or signaling, heads up displays, fully transparent displays, flexible displays, laser printers, telephones, cell phones, personal digital assistants (PDAs), laptop computers, digital cameras, camcorders, viewfinders, micro-displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C.).

The materials, structures and methods described herein may have applications in devices other than OLEDs. For example, other optoelectronic devices such as organic solar cells and organic photodetectors may employ the materials and structures. More generally, organic devices, such as organic transistors, may employ the materials and structures.

OVJP is a desirable method for depositing organic materials in many circumstances. OVJP may allow for the deposition of organic molecules in shapes or patterns defined by the nozzle through which the jet is formed, without the use of a mask, photoresist, or similar patterning techniques based on blocking off or hiding parts of the substrate onto which deposition is not desired. However, if parts of the substrate where deposition is not desired are left uncovered, stray molecules may present issues.

A fundamental limitation of organic vapor jet printing (OVJP) is that molecules emitted from the nozzle tip do not all stick to the substrate at the first impact, i.e. the sticking coefficient for organic molecules is rarely if ever 1.0. Molecules that rebound from the substrate or are re-evaporated after deposition are likely to diffuse around the vacuum chamber and land on areas of the substrate outside of the intended pattern, which can cause color contamination, efficiency decreases, voltage rises or all three. A further problem is that the hot OVJP nozzle close to the substrate surface causes heating of the substrate surface which lowers the sticking coefficient and promotes re-evaporation.

Cooling the substrate from the back side is one possible way to mitigate these issues. However, cooling the substrate from the back side may have limited effectiveness because of poor thermal contact between the cooling plate and the substrate, sometimes exacerbated by a low thermal conductivity of the substrate itself, i.e. it is the front surface temperature that is important not the back surface.

In general, the nozzle or nozzles of an OVJP system are in fluid communication with a source of carrier gas and a source of organic molecules. An active cooling system disposed adjacent to the nozzle, such as a "chiller plate," may reduce the average temperature of the substrate by improving heat transfer from the substrate. By adjacent we mean close to, but not in contact with, the nozzle. Preferably the active cooling system is not so close as to interfere with the ability of the heater to keep the nozzle above the sublimation temperature of the organic molecules. The active cooling system may also capture molecules that re-evaporate or rebound from the substrate, reducing the number of such molecules that deposit outside of the desired pattern.

As used herein, a "nozzle" is a mechanism that directs, guides, or otherwise controls the flow of material after it exits the mechanism.

Some, but not all, OVJP systems involve deposition in a chamber. Many OVJP systems also involve a substrate holder adapted to support a substrate beneath the nozzle, and to move relative to the nozzle. The nozzle, the substrate holder, or both may move. Where a chamber is used, the nozzle and substrate holder may be within the chamber. The use of a chamber allows for better control of ambient conditions, such as background pressure, gas composition, and temperature. As used herein, "beneath" the nozzle means disposed in the direction that the nozzle points, i.e., that the nozzle points at the substrate. The nozzle may be oriented in any number of directions in the substrate.

Embodiments of the invention may be practiced across a wide variety of dimensions. Active cooling systems adjacent to a nozzle of an OVJP systems may be used advantageously at any dimensions that are desired for an OVJP system. Preferably, the substrate onto which OVJP is being performed is held by a substrate holder such that the substrate is disposed at a distance of 0.1 to 10 mm from the active cooling system. This distance allows for reasonably good heat transfer from the substrate to the active cooling system. This distance also makes it reasonably probable that any molecule that re-evaporates from the substrate or that rebounds during deposition will hit the active cooling system before finding its way back to the substrate or some other possibly undesirable location. Preferably, the active cooling system is within one mean free path of the substrate.

Preferably, a heating system is attached to the nozzle. Preferably, the points at which the heating system are attached to the nozzle includes at least one point that is zero to 5 mm from the tip of the nozzle. The organic molecules typically involved in OVJP have a sublimation temperature of 150 to 400 C. It is desirable to maintain the temperature of the nozzle at a temperature that exceeds the sublimation temperature of the organic molecules. Otherwise, the molecules may undesirably condense on the nozzle, possibly clogging the nozzle. In conventional OVJP systems, a heating system attached further from the tip of the nozzle, or on tubes leading to the nozzle, may provide heating sufficient to avoid such condensation. In addition, some heating may be provided by the carrier gas stream itself. However, when an active cooling system is introduced adjacent to the nozzle, heating systems previously disclosed for use with OVJP may not be sufficient to avoid undesirable condensation on the nozzle. A heating system close to the tip of the nozzle may be used to avoid such condensation, even when an active cooling system is present.

An "active cooling system" is a system that removes heat from the vicinity of the substrate surface, particularly around the nozzle. An active cooling system will generally involve the expenditure of power as a part of the cooling. Examples of active cooling systems include cooling fluid tubes, plates having channels therein for cooling fluid, plates having cooling fluid tubes attached thereto, and a thermoelectric cooler. A heat pipe may also be considered an active cooling system, the heat pipe is thermally connected to a heat sink that is cooled using power. Other active cooling systems may be used.

A "heating system attached to the nozzle" is a system that provides heat to the nozzle. Examples of such heating systems include resistive wires, resistive elements on the nozzle itself or on some other structure attached to the nozzle, a laser beam focused on the nozzle, a radio frequency field coupled to the nozzle, and the hot side of a thermoelectric cooler. A heating system "attached to the nozzle" involves something more than heat from a gas stream that is heated remotely from the nozzle and then transmitted to and passed through the nozzle. Heating systems other than those specifically described herein may be used.

In one embodiment, the heating system is a resistive wire wrapped around the nozzle, and the active cooling system is a cooling fluid tube wrapped around the heating system.

In one embodiment, a thermoelectric cooler having a hot side and a cool side may serve as part of both the active cooling system and the heating system. Preferably, the thermoelectric cooler may be the active cooling system, and a part of the heating system (i.e., there is an additional heat source that is part of the heating system). Some thermoelectric coolers may also be known as "Peltier coolers." Connecting a DC power source to a thermoelectric cooler results in a hot side and a cool side. The hot side of such a cooler may be used as the heating system, while the cool side serves as the active cooling system. In this embodiment, the thermoelectric cooler is preferably shaped such that the hot side is closest to the nozzle, while the cool side is adjacent to the substrate and further away from the nozzle than the hot side.

Preferably, a thermal insulating material is disposed between the nozzle and the active cooling system. The thermal insulating material may help to maintain a large thermal gradient between the active cooling system and the nozzle. This is desirable because the nozzle should be hot relative to the active cooling system, to avoid undesirable condensation on the nozzle. At the same time, the active cooling system should be cool relative to the nozzle, because condensation of re-evaporated and rebounding molecules on the active cooling system is desirable, and because lower temperatures at the active cooling system may remove heat from the substrate.

One embodiment of an active cooling system is a plate having an aperture therein, such that the nozzle extends through the aperture. The plate preferably has a high thermal conductivity, and has channels for cooling fluid. These fluid channels may be within the plate itself. The fluid channels may be attached to the back of the plate, for example a copper tube welded to the plate. The "back" of the plate is the side away from the substrate where organic molecules are to be deposited. Preferred cooling fluids include water, ethylene glycol, water / ethylene glycol mixtures, and liquid nitrogen. The cooling fluids may be maintained at a low temperature and pumped through the channels by any known method. The active cooling system is preferably adapted to maintain a plate temperature of -100C to 100C. The geometry and materials of the channels and the plate, as well as the temperature and circulation rate of the cooling fluid, may be adjusted to maintain a desired temperature, even when the nozzle is heated due to the presence of a heating system and / or the heat of the ejected jet.

Preferably, the nozzle protrudes from the front of the active cooling system, by zero to 10 mm. For example, where the active cooling system is a plate having an aperture for the nozzle, the nozzle preferably protrudes from the aperture by zero to 10 mm. If the nozzle were recessed in the aperture, there might be undesirable condensation of organic molecules on the active cooling system directly from the jet before the molecules reach the substrate, as opposed to desirable primary condensation on the substrate with desirable secondary condensation on the active cooling system of organic molecules that rebound from the substrate or re-evaporate. At the upper end of the range, protrusion of the nozzle from the active cooling system limits how close the active cooling system may be to the substrate. It is desirable minimize the distance between the active cooling system and the substrate, to facilitate heat transfer from the substrate to the active cooling system and to increase the chance that a rebounding or re-evaporated organic molecule hits the active cooling system before hitting anything else, such as the substrate outside of the desired patterned area. For the same reasons, the nozzle preferably protrudes from the aperture by 0 to 10 times the diameter of the interior of the nozzle at its tip. No protrusion (i.e., a protrusion of zero) may be preferred. These protrusion distances, and even any protrusion, are not necessarily present, but they are preferred.

An active cooling system may be useful for a wide variety of OVJP resolutions. At higher resolutions, the maximum theoretical effectiveness of an active cooling system may be determined by the maximum obtainable temperature gradient within the small volume of a nozzle array. Low resolution embodiments may be simpler to implement.

Where multiple nozzles are present, it is preferred that an active cooling system is disposed adjacent to each nozzle, including between the nozzles.

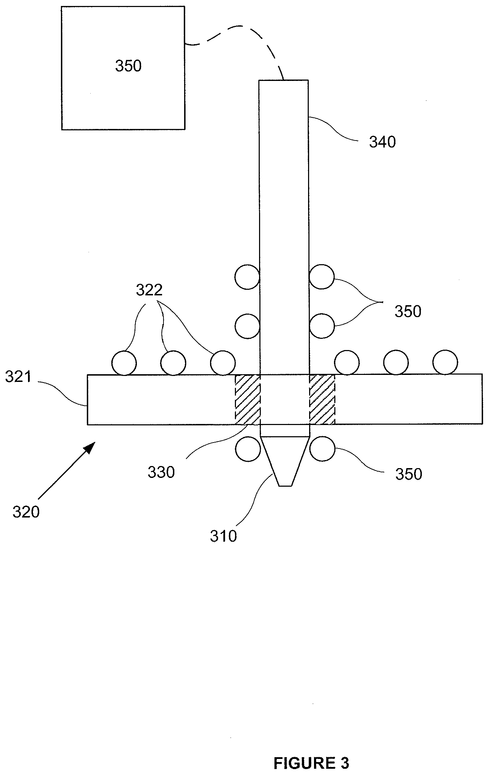

A simple, single nozzle implementation of an active cooling system is an annular plate around the nozzle tip as shown in FIG. 3. The plate may be closer to the nozzle tip than is shown. Preferably, the plate is located about one nozzle diameter above the nozzle aperture and extends in all directions parallel to the substrate. Ideally the temperature of the chiller plate will be less than 10C. The preferred temperature may depend somewhat on the background pressure of the OVJP chamber,- if the plate is made too cold with too high a background pressure, the plate may function as a cryopump and compete with the principal chamber pumping, which is undesirable. In a chamber with a base pressure in the millitorr range, the preferred temperature for the chiller plate will be in the -20C - 0C range. This range may be achieved, for example, using a recirculating chiller with an ethylene glycol-based working fluid. In a high vacuum chamber, however, a much lower temperature might be desirable, such as temperatures obtainable using liquid nitrogen as a coolant.

A one dimensional array of nozzles (i.e., a line of nozzles) is a preferred embodiment for a nozzle block. Such an array allows for high throughput patterning by moving the nozzle relative to the substrate or vice versa in the direction perpendicular to the line of the nozzles. In such an embodiment, other nozzles may limit the space available for an active cooling system in the direction of the line of nozzles, but there should be ample space in other directions for an active cooling system. Other arrangements of multiple nozzles, such as a two dimensional array, may also be used. A variety of nozzle shapes may be used. For example, the nozzles may be elongated, e.g. rectangular, preferably with the long axis in the direction of translation of the array relative to the substrate.

In a multi-nozzle array, the array may have multiple openings, one for each nozzle. To the extent that the active cooling system is disposed between the nozzles, it may create a localized lower vacuum level in between the nozzles which may function in a similar manner to the inter-nozzle exhaust described in WO 2008/088446.

A method of depositing organic molecules via OVJP is provided. A nozzle, a source of carrier gas and a source of organic molecules in fluid communication with the nozzle, an active cooling system disposed adjacent to the nozzle, and a heating system attached to the nozzle are provided. Organic molecules are deposited onto a substrate by ejecting through the nozzle the organic molecules carried by the carrier gas. While depositing the organic molecules, the nozzle is heated with the active heating system, and the active cooling system is maintained at a cool temperature, lower than it would be in the absence of active cooling.

Preferably, the substrate is disposed at a distance of 0.1 to 10 mm from the active cooling system while the organic molecules are being deposited. Preferably, the active cooling system is maintained at a temperature of -100C to 100C while the organic molecules are being deposited. Preferably, multiple nozzles are provided, where the active cooling system is disposed adjacent to each nozzle. Preferably, organic molecules are deposited to a thickness of 10 nm to 5000 nm in regions of the substrate underneath the nozzles, and where any organic molecules deposited in regions of the substrate not underneath the nozzles are deposited to a thickness of zero to one monolayer. Preferably, the nozzle is maintained at a temperature of 150C to 400C while the organic molecules are being deposited.

An organic light emitting device is also provided. The device may include an anode, a cathode, and an organic emissive layer disposed between the anode and the cathode. The organic emissive layer may include a host and a phosphorescent dopant.

FIG. 3 shows an example of a nozzle with an adjacent active cooling system. Nozzle 310, at the end of tube 340, is the nozzle of an organic vapor jet printing system. Tube 340 provides fluid communication from the nozzle to a source of carrier gas and a source of organic molecules in fluid communication with the nozzle. The source of carrier gas and source of organic molecules are represented as source 350. Active cooling system 320 is disposed adjacent to nozzle 310. Active cooling system 320 is a plate 321 having cooling tubes 322 attached to the back thereof. Cooling tubes 320 may be attached to a source of chilled fluid, which circulates through the cooling tubes. Nozzle 310 protrudes through an aperture in plate 321. An insulator 330 provides thermal insulation between tube 340 and plate 321. A heating system is attached to nozzle 310. Specifically, heating elements 350, which may be resistive wires, for example, are attached to nozzle 310.

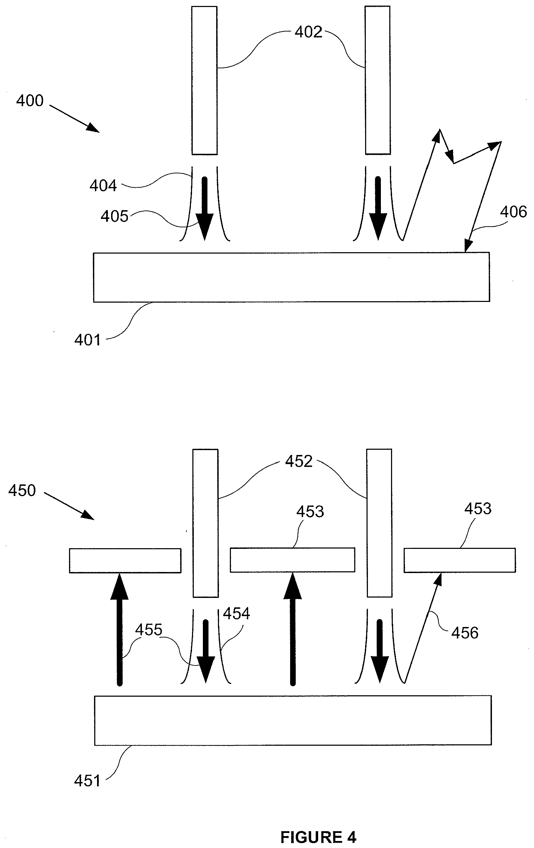

FIG. 4 shows an OVJP system 400 that does not have an active cooling system, as contrasted to an OVJP system 450 that does have an active cooling system. OVJP system 400 includes nozzles 402 that eject gas 404 onto substrate 401. Arrows 405 illustrates the transfer of heat from the ejected gas 404 and the hot nozzles 402 to substrate 401. Arrows 406 illustrate the path of a molecule that either rebounds from substrate 401 or re-evaporates after deposition, and ends up deposited on substrate 401 in a position that is not under nozzles 402. OVJP system 450 includes nozzles 452 that eject gas 454 onto substrate 451. Arrows 455 illustrate the transfer of heat from the ejected gas 454 and the hot nozzles 452 to substrate 451, and subsequently to active cooling system 453. Arrows 456 illustrate the path of a molecule that either rebounds from substrate 451 or re-evaporates after deposition. The molecule hits active cooling system 453, and sticks to active cooling system 453 due to its low temperature. While active cooling system 453 is illustrated as a plate similar to that shown in FIG. 3, other configurations may be used.

FIG. 5 shows a series of devices used to illustrate issues with devices caused by overspray. On a substrate 500, several devices 510 were fabricated. The devices were in the shape of lines. Each line was 1mm wide, and the separation between lines was 1.5 mm. A total of 13 lines were fabricated, although only the middle 7 lines lustrated in FIG. 5. The middle line is labeled r0, and each pair of lines moving outward are numbered r1, r2, r3, r4, r5 and r6. Substrate 500 was a 6 inch by 6 inch glass substrate, having lines of indium tin oxide patterned thereon. α-NPD (N,N'-di(1-naphthyl)-N,N'-diphenylbenzidine) was blanket deposited over the indium tin oxide using VTE to a thickness of 400A. Then, a single line of Compound 1 was printed over line r0 using OVJP. The nozzle had an inside diameter of 1mm, and was passed along the length of line r0 at a speed of 8 mm/s and a distance of 1 mm. Compound 1 was not deliberately deposited on lines r1-r6, but neither were they masked during the deposition onto line r0, such that they may receive some deposition of Compound 1 due to overspray. Then, 2,9-dimethyl-4,7-diphenyl-1,10-phenanthroline (BCP) was blanket deposited using VTE to a thickness of 400A. A top electrode of LiF (12 A) and Al (1000 A) was then deposited over the BCP.

Compound 1 has the structure:

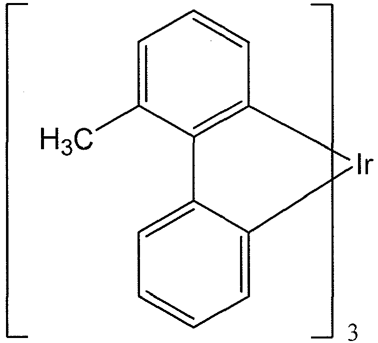

In the devices described with respect to FIG. 5, it is expected that the device at r0 will exhibit green emission from Compound 1, which is a green phosphorescent emitter. In the absence of overspray issues, it is expected that devices at r1-r6 will exhibit blue emission from the α-NPD.

Two sets of devices as shown in FIG. 5 were fabricated. In the first set, the OVJP was performed without the use of an active cooling system. In the second set, an active cooling system, in the form of a plate cooled to -10C, was in place during deposition.

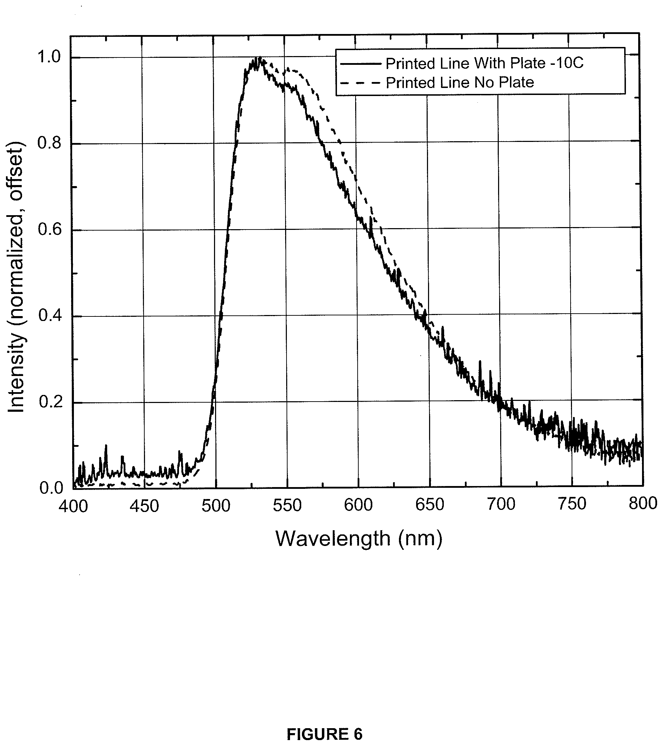

FIG. 6 shows the emission spectra from line r0 of the first set of devices,'shown as a solid line, and the emission spectra from line r0 of the second set of devices, shown as a dashed line. The emission spectra of FIGS. 6-9 are normalized to a peak intensity of 1. The emission from line r0 of both sets of devices had peaks at about 530 nm, which is consistent with emission from Compound 1. The spectrum for the line deposited with an active cooling system was slightly narrower, which may be due to a cleaner deposition.

FIG. 7 shows the emission spectra from line r1 of the first set of devices, shown as a solid line, and the emission spectra from line r1 of the second set of devices, shown as a dashed line. The spectrum for the line deposited with an active cooling system shows a peak at about 430 nm, and a shape that is consistent with emission from α-NPD relatively uncontaminated with other molecules, such as Compound 1. However, the spectrum for the line deposited without an active cooling system shows a peak at about 430 nm, and a lesser peak at about 525 nm. This spectrum shows that the device at r1 fabricated without an active cooling system has significant contamination from Compound 1, which causes the peak at about 525 nm. Figure 7 illustrates that, without the use of an active cooling system, when Compound 1 is deposited at r0 via OVJP, there is enough overspray at r1 to significantly affect the emission properties of the device. The overspray is significantly reduced or eliminated when an active cooling system is used during OVJP.

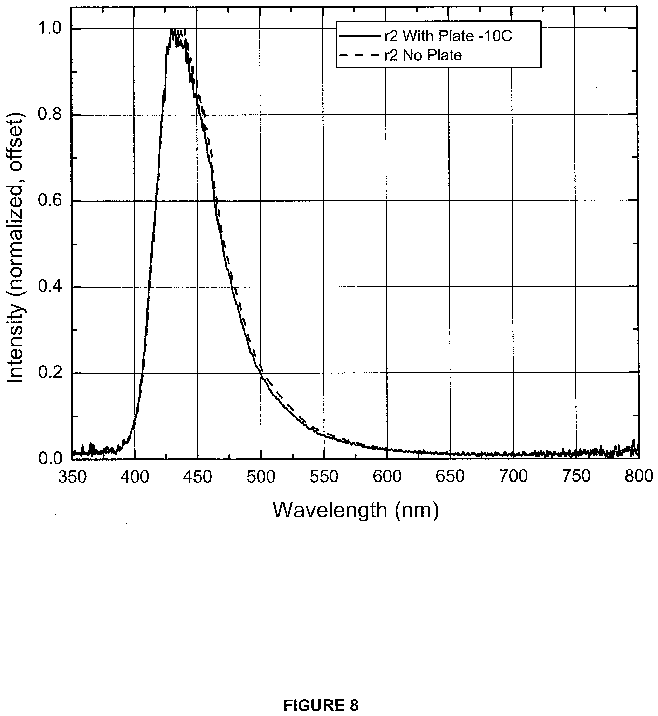

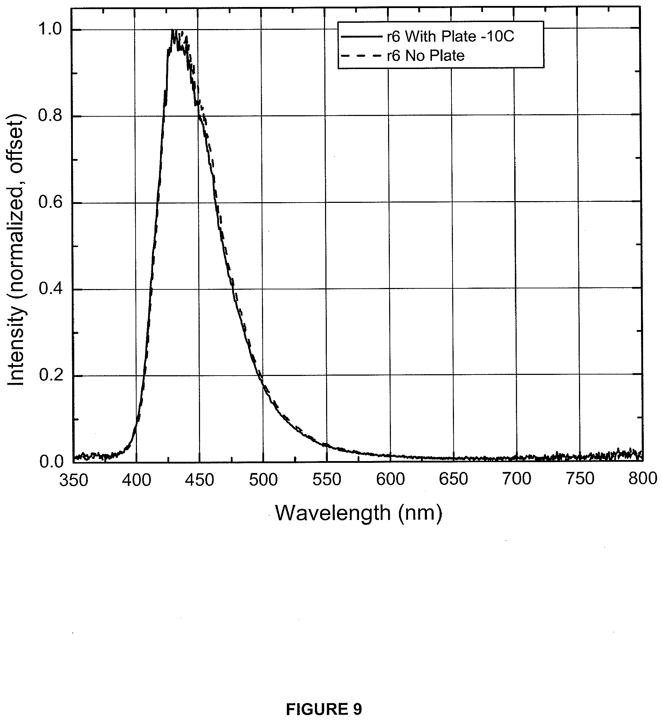

FIG. 8 shows the emission spectra from line r2 of the first set of devices, as a solid line, and the emission spectra from line r1 of the second set of devices, shown as a dashed line. FIG. 9 shows similar data for line r3. FIG. 8 shows a slight broadening of the spectra from the first set of devices on the right side, compared to the spectra from the second set of devices. FIG. 9 shows a similar broadening, but to a lesser extent. The same type of broadening was observed in lines r4 through r6, with the extent of the broadening decreasing as distance from r0 increased. This data shows that the first set of devices, deposited without the use of an active cooling system, exhibits contamination from Compound 1 due to overspray as far away as line r6, and that the use of an active cooling system reduces or eliminates such contamination.

## Claims

1. A device, comprising:
an organic vapor jet printing (OVJP) nozzle;
a heating system (350) attached to the nozzle;
a source of carrier gas and a source of organic molecules in fluid communication, via a tube (340), with the nozzle; and
an active cooling system disposed adjacent to the nozzle and separated from the tube by an insulator (330),
wherein the nozzle protrudes from the front of the active cooling system by zero to 10 mm;
wherein, when the nozzle is disposed above a substrate toward which the organic molecules are directed by the nozzle, the active cooling system is disposed above the substrate, such that the active cooling system is configured to capture organic molecules that re-evaporate or rebound from the substrate.

2. The device of claim 1, further comprising:
a chamber, wherein the nozzle, and the active cooling system are disposed within the chamber;
a substrate holder disposed within the chamber, adapted to support a substrate beneath the nozzle, movable relative to the nozzle.

3. The device of claim 1, further comprising a substrate held by the substrate holder, wherein the substrate is disposed at a distance of 0.1 to 10 mm from the active cooling system.

4. The device of claim 1, wherein the points at which the heating system are attached to the nozzle includes at least one point that is zero to 5 mm from the tip of the nozzle.

5. The device of claim 1, wherein the active cooling system is a plate having an aperture therein, and the nozzle extends through the aperture.

6. The device of claim 5, wherein the nozzle protrudes from the aperture by zero to 10 mm.

7. The device of claim 5, wherein the nozzle protrudes from the aperture by 0 to 10 times the diameter of the interior of the nozzle at its tip.

8. The device of claim 5, wherein the active cooling system further comprises cooling fluid channels in the plate.

9. The device of claim 8, wherein a cooling fluid is enclosed in the channels, and the cooling fluid is selected from the group consisting of ethylene glycol and liquid nitrogen.

10. The device of claim 1, wherein the active cooling system further includes channels attached to the back of the plate.

11. The device of claim 1, wherein the active cooling system is adapted to maintain a plate temperature of -100C to 100C.

12. The device of claim 1, wherein the device includes multiple nozzles, wherein the active cooling system is disposed adjacent to each nozzle.

13. The device of claim 1, further comprising a thermally insulating material disposed between the nozzle and the active cooling system.

14. The device of claim 1, wherein:
the heating system further comprises a resistive wire wrapped around the nozzle; and
the active cooling system further comprises a cooling fluid tube wrapped around the heating system.

15. The device of claim 1, wherein the device further comprises a thermoelectric cooler having a hot side and a cool side.

16. The device of claim 15, wherein the cool side of the thermoelectric cooler is the active cooling system, and the hot side of the thermoelectric cooler is part of the heating system.

17. An organic vapor jet printing method, comprising:
providing:
an organic vapor jet printing (OVJP) nozzle;
a source of carrier gas and a source of organic molecules in fluid communication with the nozzle;
an active cooling system disposed adjacent to the nozzle, wherein the nozzle protrudes from the front of the active cooling system by zero to 10 mm; and
a heating system attached to the nozzle;
depositing the organic molecules onto a substrate by ejecting through the nozzle the organic molecules carried by the carrier gas,
wherein, while depositing the organic molecules,
heating the nozzle with the active heating system, and
cooling the active cooling system,
wherein, when the nozzle is disposed above a substrate toward which the organic molecules are directed by the nozzle, the active cooling system is disposed above the substrate, such that the active cooling system captures organic molecules that re-evaporate or rebound from the substrate.

18. The method of claim 17, wherein the substrate is disposed at a distance of 0.1 to 10 mm from the active cooling system while the organic molecules are being deposited.

19. The method of claim 17, wherein the active cooling system is maintained at a temperature of -100C to 100C while the organic molecules are being deposited.

20. The method of claim 17, wherein the multiple nozzles are provided, and wherein the active cooling system is disposed adjacent to each nozzle.

21. The method of claim 17, wherein the nozzle is maintained at a temperature of 150C to 400C while the organic molecules are being deposited.

## Patentansprüche

1. Vorrichtung umfassend:
eine organische Dampfstrahldruck (OVJP) - Düse;
ein Heizsystem (350), das an der Düse befestigt ist;
eine Trägergasquelle und eine organische Molekülquelle, die über ein Rohr (340) in Fluidverbindung mit der Düse stehen; und
ein aktives Kühlsystem, das angrenzend an der Düse und durch einen Isolator (330) von dem Rohr getrennt angeordnet ist,
wobei die Düse von der Vorderseite des aktiven Kühlsystems um null bis 10 mm vorsteht;
wobei, wenn die Düse über einem Substrat angeordnet ist, auf das die organischen Moleküle durch die Düse gerichtet sind, das aktive Kühlsystem derart über dem Substrat angeordnet ist, dass das aktive Kühlsystem ausgebildet ist, organische Moleküle einzufangen, die von dem Substrat nachverdampfen oder abprallen.

2. Vorrichtung nach Anspruch 1, ferner umfassend:
eine Kammer, wobei die Düse und das aktive Kühlsystem innerhalb der Kammer angeordnet sind;
einen Substrathalter, der innerhalb der Kammer angeordnet ist und ausgebildet ist, ein relativ zu der Düse bewegliches Substrat unterhalb der Düse, zu lagern.

3. Vorrichtung nach Anspruch 1, ferner umfassend ein von dem Substrathalter gehaltenes Substrat, wobei das Substrat in einer Entfernung von 0.1 bis 10 mm von dem aktiven Kühlsystem angeordnet ist.

4. Vorrichtung nach Anspruch 1, wobei die Punkte, an welchen das Heizsystem an der Düse befestigt sind, zumindest einen Punkt aufweisen, der null bis 5 mm von der Spitze der Düse entfernt ist.

5. Vorrichtung nach Anspruch 1, wobei das aktive Kühlsystem eine Platte mit einer Öffnung darin ist, und sich die Düse durch die Öffnung erstreckt.

6. Vorrichtung nach Anspruch 5, wobei die Düse von der Öffnung um null bis 10 mm vorsteht.

7. Vorrichtung nach Anspruch 5, wobei die Düse von der Öffnung um null bis 10 mal den Innendurchmesser der Düse an seiner Spitze hervorsteht.

8. Vorrichtung nach Anspruch 5, wobei das aktive Kühlsystem ferner Kühlfluidkanäle in der Platte umfasst.

9. Vorrichtung nach Anspruch 8, wobei ein Kühlfluid in den Kanälen enthalten ist und das Kühlfluid aus der Gruppe bestehend aus Ethylenglycol und flüssigem Stickstoff ausgewählt ist.

10. Vorrichtung nach Anspruch 1, wobei das aktive Kühlsystem ferner an der Rückseite der Platte befestigte Kanäle aufweist.

11. Vorrichtung nach Anspruch 1, wobei das aktive Kühlsystem ausgebildet ist, eine Plattentemperatur von -100C bis 100C aufrechtzuerhalten.

12. Vorrichtung nach Anspruch 1, wobei die Vorrichtung eine Vielzahl von Düsen aufweist, wobei das aktive Kühlsystem angrenzend an jede Düse angeordnet ist.

13. Vorrichtung nach Anspruch 1, ferner umfassend ein wärmeisolierendes Material, das zwischen der Düse und dem aktiven Kühlsystem angeordnet ist.

14. Vorrichtung nach Anspruch 1, wobei:
das Wärmesystem ferner einen Widerstandsdraht aufweist, der um die Düse gewickelt ist; und
das aktive Kühlsystem ferner ein Kühlfluidrohr umfasst, das um das Wärmesystem gewickelt ist.

15. Vorrichtung nach Anspruch 1, wobei die Vorrichtung ferner eine thermoelektrische Kühlung umfasst, die eine heiße Seite und eine kalte Seite aufweist.

16. Vorrichtung nach Anspruch 15, wobei die kalte Seite der thermoelektrischen Kühlung das aktive Kühlsystem ist und die heiße Seite der thermoelektrischen Kühlung Teil des Heizsystems ist.

17. Organisches Dampfstrahldruckverfahren, umfassend:
Bereitstellen:
einer organischen Dampfstrahldruck (OVJP) - Düse;
einer Trägergasquelle und einer organischen Molekülquelle, die in Fluidverbindung mit der Düse stehen;
eines aktives Kühlsystems, das angrenzend an die Düse angeordnet ist, wobei die Düse von der Vorderseite des aktiven Kühlsystems um null bis 10 mm vorsteht; und
eines Heizsystems, das an der Düse befestigt ist;
Ablagern der organischen Moleküle auf einem Substrat durch Ausstoßen der durch das Trägergas getragenen organischen Moleküle durch die Düse,
wobei, während des Ablagerns der organischen Moleküle,
die Düse durch das aktive Heizsystem geheizt wird, und
das aktive Kühlsystem gekühlt wird,
wobei, wenn die Düse über einem Substrat angeordnet ist, auf das die organischen Moleküle durch die Düse gerichtet werden, das aktive Kühlsystem derart über dem Substrat angeordnet werden, dass das aktive Kühlsystem organische Moleküle einfängt, die von dem Substrat nachverdampfen oder abprallen.

18. Verfahren nach Anspruch 17, wobei das Substrat in einer Entfernung von 0.1 bis 10 mm von dem aktiven Kühlsystem angeordnet ist, während die organischen Moleküle abgelagert werden.

19. Verfahren nach Anspruch 17, wobei das aktive Kühlsystem eine Plattentemperatur von -100C bis 100C aufrechterhält, während die organischen Moleküle abgelagert werden.

20. Verfahren nach Anspruch 17, wobei eine Vielzahl von Düsen vorgesehen sind und wobei das aktive Kühlsystem angrenzend an jede Düse angeordnet ist.

21. Verfahren nach Anspruch 17, wobei die Düse bei einer Temperatur von 150C bis 400C gehalten wird, während die organischen Moleküle abgelagert werden.

## Revendications

1. Un dispositif, comprenant :
une buse d'impression par jet de vapeur organique (OVJP),
un système de chauffage (350) fixé à la buse ;
une source de gaz porteur et une source de molécules organiques en communication fluidique, via un tube (340), avec la buse ; et
un système de refroidissement actif disposé de façon adjacente à la buse et séparé du tube par un isolant (330),
la buse faisant saillie sur zéro à 10 mm de l'avant du système de refroidissement actif ;
le système de refroidissement actif étant, lorsque la buse est disposée au-dessus d'un substrat vers lequel les molécules organiques sont dirigées par la buse, disposé au-dessus du substrat, de sorte que le système de refroidissement actif est configuré pour capturer des molécules organiques qui se ré-évaporent du substrat ou qui rebondissent depuis celui-ci.

2. Le dispositif selon la revendication 1, comprenant en outre :
une chambre, la buse et le système de refroidissement actif étant disposés à l'intérieur de la chambre ;
un support de substrat disposé à l'intérieur de la chambre, adapté pour supporter un substrat en dessous de la buse, mobile par rapport à la buse.

3. Le dispositif selon la revendication 1, comprenant en outre un substrat maintenu par le support de substrat, le substrat étant disposé à une distance de 0,1 à 10 mm du système de refroidissement actif.

4. Le dispositif selon la revendication 1, dans lequel les points au niveau desquels le système de chauffage est fixé à la buse comportent au moins un point situé à une distance de zéro à 5 mm de l'extrémité de la buse.

5. Le dispositif selon la revendication 1, dans lequel le système de refroidissement actif est une plaque présentant une ouverture en lui, et la buse s'étend à travers cette ouverture.

6. Le dispositif selon la revendication 5, dans lequel la buse fait saillie de zéro à 10 mm de l'ouverture.

7. Le dispositif selon la revendication 5, dans lequel la buse fait saillie de l'ouverture sur 0 à 10 fois le diamètre de l'intérieur de la buse à son extrémité.

8. Le dispositif selon la revendication 5, dans lequel le système de refroidissement actif comprend en outre des canaux de fluide de refroidissement dans la plaque.

9. Le dispositif selon la revendication 8, dans lequel un fluide de refroidissement est enfermé dans les canaux et le fluide de refroidissement est choisi dans le groupe constitué par l'éthylène glycol et l'azote liquide.

10. Le dispositif selon la revendication 1, dans lequel le système de refroidissement actif comprend en outre des canaux fixés à l'arrière de la plaque.

11. Le dispositif selon la revendication 1, dans lequel le système de refroidissement actif est adapté pour maintenir une température de plaque allant de -100C à 100C.

12. Le dispositif selon la revendication 1, dans lequel le dispositif comprend une pluralité de buses, le système de refroidissement actif étant disposé de façon adjacente à chaque buse.

13. Le dispositif selon la revendication 1, comprenant en outre un matériau thermiquement isolant disposé entre la buse et le système de refroidissement actif.

14. Le dispositif selon la revendication 1, dans lequel :
le système de chauffage comprend en outre un fil résistif enroulé autour de la buse ; et
le système de refroidissement actif comprend en outre un tube de fluide de refroidissement enroulé autour du système de chauffage.

15. Le dispositif selon la revendication 1, dans lequel le dispositif comprend en outre un refroidisseur thermoélectrique ayant un côté chaud et un côté froid.

16. Le dispositif selon la revendication 15, dans lequel le côté froid du refroidisseur thermoélectrique est le système de refroidissement actif et le côté chaud du refroidisseur thermoélectrique fait partie du système de chauffage.

17. Un procédé d'impression par jet de vapeur organique, comprenant :
le fait de prévoir :
une buse d'impression par jet de vapeur organique (OVJP) ;
une source de gaz porteur et une source de molécules organiques en communication fluidique avec la buse ;
un système de refroidissement actif disposé de façon adjacente à la buse, la buse faisant saillie sur zéro à 10 mm de l'avant du système de refroidissement actif ; et
un système de chauffage fixé à la buse ;
le fait de déposer les molécules organiques sur un substrat en éjectant à travers la buse les molécules organiques portées par le gaz porteur,
le fait, tout en déposant les molécules organiques, de chauffer la buse avec le système de chauffage actif, et
le fait de refroidir le système de refroidissement actif ;
le système de refroidissement actif étant, lorsque la buse est disposée au-dessus d'un substrat vers lequel les molécules organiques sont dirigées par la buse, disposé au-dessus du substrat, de sorte que le système de refroidissement actif capture les molécules organiques qui se ré-évaporent du substrat ou rebondissent sur celui-ci.

18. Le procédé selon la revendication 17, dans lequel le substrat est disposé à une distance de 0,1 à 10 mm du système de refroidissement actif pendant que les molécules organiques sont déposées.

19. Le procédé selon la revendication 17, dans lequel le système de refroidissement actif est maintenu à une température de -100C à 100C pendant que les molécules organiques sont déposées.

20. Le procédé selon la revendication 17, dans lequel des buses multiples sont prévues, et
dans lequel le système de refroidissement actif est disposé de façon adjacente à chaque buse.

21. Le procédé selon la revendication 17, dans lequel la buse est maintenue à une température de 150C à 400C pendant que les molécules organiques sont déposées.
